# EUROPÄISCHE PATENTSCHRIFT

(11) **EP 3 173 693 B1**
(45) Veröffentlichungstag und Bekanntmachung des Hinweises auf die Patenterteilung: **13.06.2018**
(21) Anmeldenummer: 16200679.5
(22) Anmeldetag: 25.11.2016
(51) Int. Cl.: F21V 23/00, F21V 8/00, F21S 8/00, G02B 6/00, F21Y 115/10, F21Y 105/10, F21Y 105/16, F21W 131/10

(54) **LEUCHTE UMFASSEND EINE ANZAHL LED-LEUCHTMITTEL**
LUMINAIRE COMPRISING A NUMBER OF LED LIGHTING MEANS
APPAREIL D'ÉCLAIRAGE COMPRENANT UNE PLURALITÉ D'AMPOULES À DEL

(30) Priorität: 25.11.2015 DE 102015120425
(43) Veröffentlichungstag der Anmeldung: 31.05.2017
(73) Patentinhaber: Irlbacher Blickpunkt Glas GmbH, 92539 Schönsee (DE)
(72) Erfinder: Irlbacher, Günther, 92539 Schönsee (DE)
(74) Vertreter: Fritz, Edmund Lothar

(56) Entgegenhaltungen:
- WO-A1-2009/111494
- DE-A1-102013 102 967
- US-A1- 2005 174 802
- US-A1- 2009 225 565
- US-A1- 2010 091 488
- US-A1- 2013 114 255

## Beschreibung

Die vorliegende Erfindung betrifft eine Leuchte umfassend eine Lichtaustrittsplatte aus einem mindestens teilweise lichtdurchlässigen Material, eine Anzahl LED-Leuchtmittel, welche ihr Licht in die Lichtaustrittsplatte hinein abgeben, wobei diese LED-Leuchtmittel jeweils in einer Vertiefung der Lichtaustrittsplatte angeordnet sind, umfassend weiter Kontaktmittel zur Kontaktierung der LED-Leuchtmittel sowie Mittel zur Stromversorgung der LED-Leuchtmittel, wobei die LED-Leuchtmittel in nur einer Lichtaustrittsplatte, in den LED-Leuchtmitteln zugeordneten Vertiefungen dieser Lichtaustrittsplatte, vollständig versenkt aufgenommen sind, wobei die Höhe der LED-Leuchtmittel geringer ist als die Tiefe der Vertiefungen oder maximal der Tiefe der Vertiefungen entspricht, wobei die Höhe der LED-Leuchtmittel weiterhin geringer ist als die Plattenstärke der Lichtaustrittsplatte und die LED-Leuchtmittel über auf die Rückseite der einen Lichtaustrittsplatte, in der sie versenkt angeordnet sind, aufgebrachte Kontaktmittel kontaktiert werden.

LEDs als Leuchtmittel verdrängen in den letzten Jahren in der Lichttechnik zunehmend die früher vorwiegend für technische Leuchten verwendeten Leuchtstofflampen, da LEDs den Vorteil eines geringen Energieverbrauchs aufweisen in Kombination mit guter elektronischer Regelbarkeit wie Dimmbarkeit, Änderung der Lichtfarbe etc. Die Lichtstärke von LEDs ist inzwischen ausreichend groß, um diese für Zwecke der Allgemeinbeleuchtung einzusetzen.

Herkömmliche LED-Leuchten verwenden in der Regel LED-Module als Leuchtmittel. Dies sind Platinen, auf denen eine größere Anzahl von LEDs zumeist in Reihen angeordnet ist. Diese LED-Module werden dann beispielsweise in einem Wandbereich in einem Leuchtengehäuse befestigt, wie dies in der EP 2 650 604 A2beschrieben ist. Das Gehäuse einer solchen herkömmlichen LED-Leuchte ist vergleichsweise großvolumig und dadurch ergibt sich eine große Aufbauhöhe der Leuchte. Bei dieser bekannten Leuchte werden weiterhin für die Lichtlenkung im Gehäuse eingebaute Reflektoren verwendet und die Lichtaustrittsöffnung des Gehäuses wird zusätzlich noch durch eine Abdeckscheibe (Lichtaustrittsplatte) abgedeckt, durch die hindurch das Licht abgestrahlt wird. Weiterhin werden für die Ableitung der von den LED-Leuchtmitteln erzeugten Wärme bei dieser bekannten Leuchte Wärmeleitpads benötigt, die die Wärme an den metallischen Gehäusekörper abgeben.

Es wurden dann vor einigen Jahren Leuchten entwickelt, bei denen die LED-Leuchtmittel unmittelbar einer mindestens teilweise transparenten Lichtaustrittsplatte, insbesondere aus Glas oder Kunststoffglas oder einem Verbund von mehreren Platten umfassend wenigstens eine Lichtaustrittsplatte zugeordnet wurden. In der WO 2006/018066 A1 ist beispielsweise ein Verbundglaselement mit wenigstens einem ersten plattenförmigen transparenten Substrat und einem zweiten transparenten plattenförmigen Substrat beschrieben, bei dem die LEDs als Leuchtmittel zwischen den beiden Platten angeordnet sind und die LED-Leuchtmittel über Leiterbahnen oder eine elektrisch leitende Schicht elektrisch versorgt werden. In dieser Druckschrift werden zwei Varianten derartiger plattenförmiger Leuchten mit LEDs beschrieben. Bei der einen Variante wird eine Verbundglasscheibe verwendet, mit zwei Glasplatten und einer Kunststoffschicht zwischen diesen beiden Platten, in der Regel einem thermoplastischen Material, und die LEDs werden in dieses Verbundmaterial eingebettet. Bei einer zweiten Variante werden auch zwei Platten (Scheiben) verwendet und in eine der Scheiben wird ein Sackloch eingebracht, in das die LED eingesetzt wird, wobei die LED auf der einen Platte sitzt und in das Sackloch der anderen Platte hineinragt. Dabei weist die LED bei der zweiten Variante eine größere Höhe auf als das Sackloch tief ist, so dass sich für den Plattenverbund eine Aufbauhöhe ergibt, die der Gesamthöhe beider Platten zuzüglich dem Abstand zwischen den beiden Platten entspricht. Bei der ersten Variante ist die Aufbauhöhe auch größer als die Summe der jeweiligen Stärke der beiden Platten, da zwischen den beiden Platten noch die Schicht aus dem Verbundmaterial liegt. Bei der zweiten Variante mit dem Sackloch sind die Dimensionen derart, dass der Durchmesser des Sacklochs um einiges größer ist als derjenige der LED. Außerdem ist die Aufbauhöhe der LED auch groß im Vergleich zu der Plattenstärke der Platte, sie entspricht in etwa der Plattenstärke, so dass es gar nicht möglich wäre, dass die LED in Tiefenrichtung vollständig in dem Sackloch aufgenommen wird. Zur Versorgung der LEDs sind bei dieser bekannten Lösung beide transparenten Scheiben mit elektrisch leitenden Bahnen versehen.

Bei der ersten Variante mit zwei Platten und einer Zwischenschicht aus Verbundmaterial strahlen die LEDs ihr Licht durch die Platten hindurch ab, so dass sie als punktförmige Lichtquellen wahrgenommen werden. Bei der zweiten Variante mit teilweise in einem Sackloch einer der Platten aufgenommen LEDs können die LED-Leuchtmittel nur teilweise ihr Licht auch seitlich in die Platte hinein abstrahlen.

Es sind im Stand der Technik auch Varianten von beleuchtbaren plattenförmigen Anordnungen mit LEDs bekannt geworden, bei denen nur eine einzige transparente Platte verwendet wird, auf der die LEDs aufgebracht sind. Eine solche Beleuchtungsvorrichtung wird in der EP 900 971 A1 beschrieben. Die LEDs sitzen hier auf der transparenten Platte. Hier ist zwar die Aufbauhöhe geringer, als bei Verwendung eines Verbunds aus mehreren Platten, aber die LEDs stehen nach oben hin vor und sind daher gegen mechanische Einflüsse nicht geschützt. Die Anwendungen derartiger Produkte sind stark eingeschränkt, denn es besteht die Gefahr, dass die LEDs beschädigt werden. Außerdem sind die verwendeten LEDs hier so groß, dass ihre Aufbauhöhe erheblich größer ist als die Stärke der Glasplatte, auf der sie befestigt sind, so dass es nicht möglich wäre, die LEDs in der Glasplatte zu versenken. Weiterhin geben die LEDs hier nicht das Licht in die Platte, auf der sie befestigt sind, ab, so dass keine gleichmäßige Lichtverteilung gegeben ist und die LEDs vom Betrachter als punktuelle Lichtquellen wahrgenommen werden.

Aus der US 2009/0174300 A1 ist eine Leuchte umfassend eine Lichtaustrittsplatte mit den eingangs genannten Merkmalen bekannt, bei der die LED in einer Bohrung einer Glasplatte versenkt angeordnet ist, wobei die Glasplatte jedoch eine Materialstärke im Bereich von 4 mm bis 6 mm aufweist. In die Glasplatte ist hier eine Bohrung eingebracht, die um einiges größer ist als der eigentliche Chip des LED-Leuchtmittels. Dieser Chip der LED wird mit Abstand umgeben von einer Linse, die die Licht lenkende Optik der LED darstellt und eine Lichtabstrahlung im Wesentlichen in senkrechter Richtung in die Tiefe der Platte hinein erzeugt. Der verbleibende Freiraum in der Bohrung wird mit einem transparenten Füllmaterial, zum Beispiel Silikon, ausgefüllt, so dass die LED in der Bohrung eingegossen ist. Das Volumen der Bohrung liegt wenigstens etwa bei dem Zehnfachen des Volumens des eigentlichen LED-Chips. Man benötigt somit eine größere Bohrung, die sich in etwa über die Hälfte der Materialstärke der Glasplatte in Tiefenrichtung erstreckt, was etwa einer Tiefe der Bohrung von 2 mm bis 3 mm entspricht. Das transparente Füllmaterial absorbiert einen Teil des von der LED abgegebenen Lichts, so dass deren Lichtausbeute verringert wird. Die Linse der zur Lichtlenkung verwendeten Optik des LED-Leuchtmittels ist so ausgebildet, dass die Lichtabgabe in senkrechter Richtung erfolgt. Außerdem nimmt die Linse einen nicht unerheblichen Bauraum in Anspruch. Es wird auch eine Variante beschrieben, bei der die Lichtabgabe in der entgegengesetzten Richtung von der Oberfläche der Glasplatte senkrecht nach oben hin erfolgt. Das Dokument DE 10 2013 102967 offenbart ein Beleuchtungsmodul mit einem Lichtleitkörper, der sich in einer vertikalen Richtung zwischen einer Vorderseite und einer Rückseite erstreckt, und mit einer Mehrzahl von zur Erzeugung von Strahlung vorgesehenen optoelektronischen Bauelementen, wobei der Lichtleitkörper an der Rückseite eine Mehrzahl von Ausnehmungen aufweist, in denen jeweils zumindest eines der optoelektronischen Bauelemente befestigt ist, und wobei die optoelektronischen Bauelemente mittels einer elektrisch leitfähigen Verbindungsschicht elektrisch kontaktiert sind. Die Aufgabe der vorliegenden Erfindung besteht darin, eine Leuchte unter Verwendung von LED-Leuchtmitteln mit den Merkmalen der eingangs genannten Gattung zu schaffen, welche einen noch flacheren Aufbau hat und verbesserte lichttechnische Eigenschaften aufweist, insbesondere eine höhere Lichtausbeute und eine andere Lichtabstrahlcharakteristik aufweist.

Die Lösung der vorgenannten Aufgabe liefert eine Leuchte der eingangs genannten Art mit den Merkmalen des Anspruchs 1.

Erfindungsgemäß ist vorgesehen, dass die LED-Leuchtmittel ihr Licht ausschließlich in die eine Lichtaustrittsplatte hinein abstrahlen, in der sie in Vertiefungen versenkt angeordnet sind und zwar sowohl seitlich zu allen Seiten hin als auch nach vorn in Plattendurchtrittsrichtung.

Bei den in der vorliegenden Erfindung verwendeten LED-Leuchtmitteln handelt es sich um solche, die noch weniger Bauraum beanspruchen. Sie weisen bevorzugt keine gesondertes Gehäuse auf und keine optischen Elemente wie Linsen oder dergleichen, die Bauraum beanspruchen, der wesentlich über das Volumen des LED-Chips selbst hinausgeht. Die Lichtabstrahlung dieser LED-Leuchtmittel erfolgt nicht nur in senkrechter Richtung nach vorn in die Lichtaustrittsplatte hinein, sondern auch zur Seite hin. Der Öffnungswinkel des abgestrahlten Lichts ist somit größer als bei den im zuvor genannten Stand der Technik verwendeten LEDs und liegt beispielsweise bei ca. 120°.

Die erfindungsgemäße Lösung hat den Vorteil, dass die Bohrung für das LED-Leuchtmittel nur noch etwa so groß sein muss wie der reine LED-Chip, welcher in der Regel bei runden LEDs eine etwa zylindrische oder bei eckigen LEDs eine etwa quaderförmige Umrissform aufweist. Die Bohrung kann somit noch erheblich kleiner werden und der Abstand zwischen dem LED-Chip und den jeweiligen Randflächen der Bohrung ist nur noch minimal. Es ist nicht notwendig, ein Füllmedium zu verwenden, welches den Chip in der Bohrung umgibt und zu Lichtverlusten führt. Eine Optik für den LED-Chip kann entweder ganz entfallen oder sie ist in den LED-Chip integriert. Ein zusätzliches den Chip umgebendes Gehäuse benötigt das LED-Leuchtmittel ebenfalls nicht, es handelt sich um so genannte "randlose" LEDs.

Ein besonders vorteilhafte Variante der Erfindung sieht vor, dass wenigstens eine der Flächen der Vertiefung, in die hinein das Licht von dem Leuchtmittel abgestrahlt wird, das heißt die Bodenfläche und/oder wenigstens eine der vier Seitenflächen der Vertiefung, geschliffene und/oder polierte Glasflächen sind. Es wurde bei Versuchen im Rahmen der vorliegenden Erfindung festgestellt, dass hierdurch die Lichtlenkung und der Anteil des von dem LED-Leuchtmittel in die Glasplatte hinein abgestrahlten Lichts und die Lichtausbeute verbessert werden können. Die Licht abgebenden Flächen des LED-Chips können dabei quasi unmittelbar an die Flächen der Vertiefung angrenzen, es genügt allenfalls ein minimaler Abstand. Gemäß der Erfindung werden dem LED-Chip keine optischen Elemente wie Linsen oder dergleichen vorgesetzt, wobei jedoch die an den LED-Chip angrenzenden geschliffenen und/oder polierten Flächen eine optische Wirkung haben und die Lichteinspeisung in die Platte und die Lichtausbeute verbessern.

Während die LED-Leuchtmittel bei bekannten Leuchten auf gesonderten Platinen (LED-Module) montiert sind, werden sie bei der erfindungsgemäßen Leuchte unmittelbar in die Vertiefungen der Lichtleitplatte eingesetzt. Die Platinen oder Chips wie sie bei vielen LED-Typen üblich sind, entfallen damit. Da die Lichtleitplatte mindestens teilweise lichtdurchlässig ist (transluzent oder gegebenenfalls auch transparent) können die in den Vertiefungen in der Lichtaustrittsplatte sitzenden LED-Leuchtmittel ihr Licht zum einen durch die Trägerplatte hindurch in Tiefenrichtung/Durchstrahlrichtung abgeben und außerdem können sie zu den Seiten hin in die Lichtaustrittsplatte hinein Licht einstrahlen, so dass diese wie eine Lichtleitplatte bei einer stirnseitigen Einstrahlung fungiert, wodurch sich eine sehr gleichmäßige Verteilung des Lichts der LED-Leuchtmittel in der Lichtaustrittsplatte und gleichmäßige Abgabe über die Fläche der Lichtaustrittsplatte ergibt, im Gegensatz zu einer punktuellen Lichtabgabe wie bei herkömmlichen Lösungen.

Ein Gehäuse ist für eine erfindungsgemäße Leuchte nicht mehr erforderlich. Die Lichtaustrittsplatte übernimmt auch statische Funktionen, denn sie dient als Träger für die Leuchtmittel und gegebenenfalls weitere Bauteile, insbesondere für den Betrieb der Leuchte notwendige elektronische Bauelemente. Überflüssige Hohlräume in einem Gehäuse, die den Bauraum einer Leuchte vergrößern, entfallen damit. Ein weiterer Vorteil ergibt sich dadurch, dass die von den LED-Leuchtmitteln erzeugte Wärme von der Lichtaustrittsplatte aufgenommen und abgeleitet wird.

Gemäß der Erfindung sind die LED-Leuchtmittel in den Vertiefungen der Lichtaustrittsplatte so versenkt angeordnet, dass die an der Rückseite des LED-Leuchtmittels angeordnete Anode und die Kathode des LED-Leuchtmittels etwa in einer Ebene mit der das LED-Leuchtmittel umgebenden Oberfläche an der Rückseite der einen Lichtaustrittsplatte liegen. Dies vereinfacht die Kontaktierung, da sich die Elektroden der LED-Leuchtmittel an deren Rückseite befinden, welche dann etwa bündig mit der Ebene der Rückseite der Lichtaustrittsplatte neben den Vertiefungen liegt, so dass man über Kontaktmittel eine elektrische Verbindung zwischen beispielsweise Leiterbahnen auf der Lichtaustrittsplatte und den Elektroden des LED-Leuchtmittels fertigungstechnisch einfach herstellen kann. Erfindungsgemäß umfassen die Kontaktmittel Kontaktblöcke oder Kontaktplättchen aus Metall, Keramik, Glas oder Kombinationen dieser Materialien, die jeweils eine elektrische Verbindung herstellen zwischen je einer Elektrode (Anode oder Kathode) des LED-Leuchtmittels und je einer auf die Lichtaustrittsplatte aufgedruckten Leiterbahn, wobei über die Kontaktblöcke auch eine Wärmeabfuhr erfolgen kann. Diese Kontaktblöcke müssen nicht rein aus Metall bestehen, sondern es kommen auch alternative Materialien wie zum Beispiel Glas oder Keramik in Betracht, beispielsweise kann man Kontaktblöcke aus Glas oder Keramik mit einer metallischen Beschichtung z.B. aus Silber oder dergleichen verwenden. Diese erfüllen auch den Zweck der Kontaktierung der LEDs und der gleichzeitigen Wärmeableitung. Es sind auch beispielsweise spezielle keramische Materialien bekannt, die eine vergleichsweise gute Wärmeleitung aufweisen. Die genannten Kontaktblöcke müssen demnach nicht so genannte 0-Ohm Widerstände sein.

Ein Unterschied zu dem eingangs genannten Stand der Technik besteht auch darin, dass die LED-Leuchtmittel vorzugsweise ihr Licht ausschließlich in die eine Lichtaustrittsplatte hinein abstrahlen, in der sie in Vertiefungen versenkt angeordnet sind und zwar sowohl seitlich zu allen Seiten hin als auch nach vorn in Plattendurchtrittsrichtung, wobei die LED-Leuchtmittel auch über Kontaktmittel dieser einen Lichtaustrittsplatte kontaktiert werden. Bei LEDs in Verbundscheiben nach dem Stand der Technik war es so, dass diese zwar Licht teilweise in eine erste Lichtaustrittsplatte hinein abstrahlen konnten, die Kontaktierung aber über eine zweite Platte erfolgen musste, auf der die LEDs saßen. Bei der vorliegenden Erfindung ist es hingegen so, dass die Platte, in die hinein das Licht abgegeben wird, auch gleichzeitig diejenige Platte ist, über die die LEDs kontaktiert werden. Dies wird dadurch möglich, dass die LED-Leuchtmittel in der Vertiefung aufgenommen werden und gehalten werden und somit nicht auf einer Platte, sondern in dieser Platte sitzen, die auch die einzige Lichtaustrittsplatte ist. Das LED-Leuchtmittel liegt dann in der jeweiligen Vertiefung so, dass seine Rückseite, an der sich die Elektroden der LED befinden, etwa bündig mit der die Vertiefung umgebenden Oberfläche der Rückseite der Lichtaustrittsplatte liegt. Die Kontaktmittel der Lichtaustrittsplatte befinden sich auf dieser rückseitigen Oberfläche der Lichtaustrittsplatte. Dadurch wird es möglich, dass die Lichtaustrittsplatte gleichzeitig die die LEDs aufnehmende und die die LEDs kontaktierende Platte ist und man so mit nur einer Platte auskommen kann.

Leuchten der erfindungsgemäßen Art weisen anders als im Stand der Technik eine Anzahl von einzelnen LED-Leuchtmitteln auf, die jeweils direkt in Vertiefungen einer transluzenten oder transparenten Lichtleitplatte/Trägerplatte aus Glas oder Kunststoff versenkt eingelassen sind. Die Kontaktierung der LEDs, um diese mit Strom zu versorgen, kann insbesondere über auf die Lichtleitplatte, bevorzugt auf der der Licht abgebenden Seite abgewandten Seite (Rückseite), aufgedruckte Leiterbahnen erfolgen. Weiterhin ist erfindungsgemäß die Lichtleitplatte selbst bevorzugt so bearbeitet (z.B. beschichtet, mattiert, bedruckt oder an der Oberfläche oder im Inneren strukturiert) dass eine effektive Lichtauskopplung des von den LEDs abgegebenen Lichts und eine gleichmäßige Lichtverteilung des abgegebenen Lichts über die lichtabstrahlende Fläche der Lichtleitplatte gewährleistet ist, das heißt, dass die einzelnen LED-Leuchtmittel für den Betrachter nicht mehr als punktuelle Lichtquellen wahrgenommen werden. Durch diese erfindungsgemäß bevorzugten Maßnahmen kann die Lichtleitplatte bei einer erfindungsgemäßen Leuchte mehrere Funktionen gleichzeitig erfüllen, für die bei herkömmlichen Leuchten jeweils separate Bauteile eingesetzt werden, nämlich zum einen die Funktion einer Trägerplatte (ersetzt quasi die Platine) für die Leuchtmittel, die unmittelbar in Vertiefungen der Platte eingesetzt werden, ohne dass Platinen mit LEDs verwendet werden. Dies ist eine platzsparende Unterbringung der LED-Leuchtmittel mit der Möglichkeit einer direkten Einspeisung des von diesen abgegebenen Lichts sowohl zu den Seiten in allen Richtungen als auch nach vorn. Das heißt das Licht wird vollständig in die Lichtaustrittsplatte selbst eingespeist, wodurch jegliche Lichtverluste vermieden werden. Zweitens dient die Lichtaustrittsplatte als Träger für weitere Bauteile, beispielsweise elektronische Bauteile für den Betrieb der LEDs, die zum Beispiel auf die Lichtaustrittsplatte aufgelötet werden können. Drittens sind die LED-Leuchtmittel in der Lichtaustrittsplatte selbst vor mechanischen Einflüssen geschützt untergebracht und es erübrigt sich, einen Sandwichaufbau mit weiteren Platten zu verwenden, wodurch die Fertigung umständlicher würde und die Aufbauhöhe der Leuchte zunehmen würde. Viertens kann die von den LEDs abgegebene Wärme direkt von der Lichtaustrittsplatte aufgenommen und abgeleitet werden, so dass sich die Verwendung von zusätzlichen Kühlelementen erübrigt. Schließlich dient die Platte, in der die LED-Leuchtmittel untergebracht sind, selbst als Lichtaustrittsplatte der Leuchte, das heißt, eine zusätzliche vorgeschaltete Lichtaustrittsplatte, die bei herkömmlichen Leuchten im Allgemeinen in einem Gehäuse gelagert wird, ist nicht mehr erforderlich. Ebenso kann auf Licht lenkende Elemente wie Reflektoren oder Streuvorrichtungen verzichtet werden, da diese Funktionen von der Lichtaustrittsplatte selbst, die gleichzeitig Lichtleitplatte ist, übernommen werden können.

Die gemäß einer bevorzugten Weiterbildung der Erfindung aufgedruckten Leiterbahnen haben den Vorteil, dass sie eine rationelle Fertigung ermöglichen, denn in einem oder mehreren Druckvorgängen können alle für die Verschaltung der LEDs und der elektronischen Bauteile notwendigen Leiterbahnen aufgebracht werden. Derartige Druckprozesse ermöglichen ein starke Automatisierung. Die sonst übliche Montage von mit LEDs oder elektronischen Bauteilen bestückten Platinen in ein Gehäuse der Leuchte entfällt.

Derartige elektronische Bauelemente können beispielsweise solche sein, die eine regelnde Funktion im Hinblick auf die Stromzufuhr oder Spannungszufuhr zu den LED-Leuchtmitteln oder die Veränderung der Helligkeit (Dimmfunktion) oder der Farbwiedergabe der LED-Leuchtmittel haben.

Eine besonders vorteilhafte Weiterbildung der Erfindung sieht vor, dass an einer zentralen Stelle der Lichtaustrittsplatte die Einspeisung des Stroms in die Leuchte erfolgt, beispielsweise über einen Stecker, wobei von dort aus Leiterbahnen zu den LED-Leuchtmitteln und/oder zu für deren Betrieb vorgesehenen elektronischen Bauelementen verlaufen.

Vorzugsweise besteht die die LED-Leuchtmitteln versenkt aufnehmende lichtdurchlässige Lichtleitplatte aus Glas oder gegebenenfalls aus Kunststoffglas, insbesondere Acrylglas. Dies sind Materialien, die sich gut bedrucken lassen.

Um den abgegebenen Lichtstrom zu beeinflussen und eine definierte möglichst gleichmäßige Lichtabgabe über einen relevanten Bereich der Lichtaustrittsplatte zu erreichen, ist diese gemäß einer bevorzugten Weiterbildung der Erfindung mindestens an ihrer Licht abstrahlenden Seite und/oder auch an den Stirnseiten mindestens in Teilbereichen mattiert, insbesondere durch Ätzen, Sandstrahlen, Schleifen, Lasern, Bedrucken oder dergleichen. Dadurch kann man eine gleichmäßigere Lichtverteilung erzielen. Das Licht wird dann nicht mehr verstärkt in den den Leuchtpunkten der LED-Leuchtmittel entsprechenden Bereichen abgestrahlt und die diskreten LED-Leuchtmittel werden vom Betrachter nicht mehr oder weniger ausgeprägt wahrgenommen. Beispielsweise kann quasi die gesamte Fläche der Lichtaustrittsplatte an ihrer Licht abgebenden Vorderseite Licht abstrahlend sein. Vorteilhaft ist dabei, dass gemäß einer bevorzugten Variante der Erfindung auch diese Mattierung in einem oder mehreren Druckvorgängen erfolgen kann, was den Herstellungsprozess der Lichtaustrittsplatte weiter rationalisiert.

Gemäß einer bevorzugten Weiterbildung der Erfindung kann man auch an der Lichtaustrittsseite der Lichtaustrittsplatte Mittel für eine Lichtlenkung vorsehen. Hierzu können beispielsweise Licht lenkende Elemente aus Glas oder Kunststoff wie zum Beispiel Linsen in die Lichtaustrittsplatte eingearbeitet sein oder auf diese aufgebracht sein durch Aufkleben, Aufschmelzen, Beschichten oder andere geeignete Methoden. Oder aber die Oberfläche der Lichtaustrittsplatte ist an der Lichtaustrittsseite strukturiert, um eine Lichtlenkung zu erzielen. Diese Lichtlenkung kann auch nur in bestimmten Bereichen erfolgen, so dass sich Kombinationen von unterschiedlichen Lichtanteilen schaffen lassen, d.h. gerichtetes und ungerichtetes Licht. Man kann auch beispielsweise kleine Reflektoren auf die Oberfläche der Lichtaustrittsplatte aufbringen, wodurch sich eine (bereichsweise) Lichtabgabe nur unter bestimmten Winkeln und somit eine gezielte Entblendung erreichen lässt.

Zwecks Veränderung der Lichtabstrahlcharakteristik der Leuchte kann man beispielsweise vorsehen, dass jeweils in einem unterschiedlichen Farbspektrum Licht abgebende und separat ansteuerbare LED-Leuchtmittel in die Lichtaustrittsplatte eingelassen sind. Dies erlaubt beispielsweise die wahlweise Abgabe von Licht in verschiedenen Weißtönen wie "warmweiß", "kalt-weiß" durch alternatives Einschalten der einen oder anderen LED oder durch deren gleichzeitiges Einschalten zur Erzeugung von Mischfarben.

Man kann beispielsweise eine weitgehend gleichmäßige Lichtstreuung über die gesamte Fläche oder gegebenenfalls nur in ausgewählten definierten Teilflächen der Lichtaustrittsplatte durch Beschichten, Bedrucken, Lasern, Sandstrahlen, Schleifen, Fräsen, Ätzen oder dergleichen erzielen.

Die Beschichtung kann beispielsweise mittels einer der gängigen im Stand der Technik bekannten Methoden zur Aufbringung dünner Schichten erfolgen, beispielsweise durch Vakuum-Beschichtung, Verdampfung (PVD), Sputtern, Plasmabeschichtung, Gasphasenabscheidung (CVD), Sol-Gel-Abscheidung, Schleuderbeschichtung, Walzenauftrag, Sprühen, Tauschbeschichtung etc.

Die erfindungsgemäße Leuchte kann für die verschiedensten Beleuchtungszwecke eingesetzt werden, zum Beispiel als Hängeleuchte, Deckenanbauleuchte, Deckeneinbauleuchte, Wandanbauleuchte, Wandeinbauleuchte, Stehleuchte oder Tischleuchte.

Weitere alternative Einsatzbereiche der erfindungsgemäßen Leuchten können zum Beispiel sein Bodeneinbauleuchten, Spiegelleuchten, Möbelleuchten oder beleuchtbare Möbelelemente, mobile Leuchten, Außenleuchten, Straßenleuchten, Orientierungsleuchten, Hinweisleuchten, oder Leuchten für eine Notbeleuchtung.

Die Anzahl der verwendeten LED-Leuchtmittel ist quasi beliebig, natürlich abhängig von der Größe und Lichtstärke der eingesetzten LED-Leuchtmittel und von der gewünschten Beleuchtungsstärke der Leuchte. Dies können beispielsweise Stückzahlen von 50 oder 100 oder mehr LEDs in einer Lichtaustrittsplatte sein.

Vorzugsweise strahlen bei einer erfindungsgemäßen Leuchte die versenkt angeordneten LED-Leuchtmittel ihr Licht ausschließlich in die Lichtaustrittsplatte hinein ab und zwar sowohl seitlich zu allen Seiten hin als auch nach vorn in Plattendurchtrittsrichtung.

Die Vertiefungen/Tiegel können zum Beispiel im Umriss rechteckig ausgebildet sein, insbesondere wenn die LED-Leuchtmittel im Umriss rechteckig sind, so dass sich eine einzelne LED passend oder nahezu passend in die jeweilige Vertiefung einsetzen lässt. Dies minimiert etwaige Lichtverluste.

Die Dimensionen der Vertiefungen sind im Rahmen der vorliegenden Erfindung nicht kritisch, es wird aber angestrebt, dass die Abmessungen der Vertiefung nicht wesentlich größer sind als diejenigen der verwendeten LEDs und bevorzugt werden vergleichsweise kleine LEDs eingesetzt, d.h. so genannte miniaturisierte SMD-LEDs, so dass die Vertiefungen beispielsweise eine Tiefe von weniger als 1,5 mm, vorzugsweise von weniger als 1 mm aufweisen. Dadurch können für die Lichtaustrittsplatte beispielsweise Glasplatten mit nur geringer Materialstärke von wenigen mm eingesetzt werden, ohne dass die LED-Leuchtmittel aus den Vertiefungen nach oben hin herausragen.

Beispielsweise beträgt die Materialstärke der Lichtaustrittsplatte weniger als 5 mm und/oder die gesamte Aufbauhöhe der Leuchte beträgt weniger als 5 mm. Es sind somit extrem flach aufgebaute Leuchten möglich, die nur aus einer einzigen vergleichsweise dünnen Glasplatte bestehen, in deren Inneren sich die kleinen LED-Leuchtmittel befinden.

Die Materialstärke der Lichtaustrittsplatten kann aber auch erheblich größer sein, wenn entsprechende Anwendungen dies fordern, beispielsweise wenn eine ausreichende Belastbarkeit der Lichtaustrittsplatte gefordert ist, wie zum Beispiel bei Bodeneinbauleuchten oder dergleichen. Hier kann somit die Plattenstärke der Lichtaustrittsplatte zum Beispiel auch 5 mm bis 10 mm oder 5 mm bis 20 mm betragen.

Zum Beispiel beträgt die Größe der Vertiefungen in Richtung ihrer Länge weniger als etwa 3 mm und die Größe der Vertiefungen in Richtung ihrer Breite beträgt weniger als etwa 2 mm.

Eine bevorzugte Weiterbildung der Erfindung sieht vor, dass in den Vertiefungen, vorzugsweise jeweils etwa in den Eckbereichen Auflagepodeste mit geringer Höhe ausgebildet sind, auf denen die LED-Leuchtmittel mit ihrer Frontseite aufliegen.

Dies hat zum Beispiel den Vorteil, dass die LED-Leuchtmittel in den Vertiefungen mittels einer geringen Menge eines aushärtenden Kunststoffs oder eines dickflüssigen Mediums eingegossen oder eingebettet werden können und dieser Kunststoff oder dieses Medium dann auch unter die untere Fläche der LED läuft. Dies ermöglicht eine einfache Befestigung der LED in der Vertiefung durch Haftverbindung.

Eine mögliche bevorzugte Lösung zur Kontaktierung der LED-Leuchtmittel sieht vor, dass die Rückseite der Lichtaustrittsplatte mit jeweils zu den Kontakten der LED-Leuchtmittel führenden Leiterbahnen bedruckt ist.

Um die Lichtauskopplung zu vereinheitlichen kann beispielsweise die Licht abgebende Vorderseite und/oder die Stirnseiten der Lichtaustrittsplatte eine vorzugsweise durch Ätzen hergestellte Mattierung aufweisen.

Mehrere für die Leuchte notwendige Funktionen kann man beispielsweise durch Bedrucken der Rückseite der Lichtaustrittsplatte schaffen, insbesondere kann man diese gegebenenfalls in mehreren aufeinanderfolgenden Druckvorgängen mit Leiterbahnen zur Versorgung der LED-Leuchtmittel, und/oder einem Lötstopplack und/oder einem Dielektrikum bedrucken.

Vorteilhaft ist bei der vorliegenden Erfindung auch die Verwendung von LED-Leuchtmitteln, die bereits auf ihrer Rückseite entsprechende Kontaktflächen aufweisen, da sich diese LED-Typen im Rahmen der erfindungsgemäßen Lösung über Kontaktblöcke, Kontaktplättchen bzw. auf die Lichtaustrittsplatte aufgedruckte Leiterbahnen besonders einfach kontaktieren lassen.

Weiterhin kann man beispielsweise eine mit Anschlussleitungen für die Stromversorgung der Leuchte verbundene Steckervorrichtung unmittelbar auf die Rückseite der Lichtaustrittsplatte auflöten und so kann über diese Steckervorrichtung und die Leiterbahnen die Stromversorgung aller LED-Leuchtmittel sowie gegebenenfalls noch weiterer elektronischer Bauelemente erfolgen.

Die in den Unteransprüchen genannten Merkmale beziehen sich auf bevorzugte Ausführungsformen der Erfindung. Weitere Vorteile der Erfindung ergeben sich aus der nachfolgenden Detailbeschreibung.

Nachfolgend wird die vorliegende Erfindung anhand von Ausführungsbeispielen unter Bezugnahme auf die beiliegenden Zeichnungen näher erläutert. Dabei zeigen:
Figur 1 eine schematisch vereinfachte Draufsicht auf eine plattenförmige Leuchte gemäß einer beispielhaften Ausführungsvariante der vorliegenden Erfindung;
Figur 2 eine zehnfach vergrößerte Ansicht eines ersten Detailausschnitts aus der Draufsicht gemäß Figur 1;
Figur 3 eine zehnfach vergrößerte Ansicht eines zweiten Detailausschnitts aus der Draufsicht gemäß Figur 1 ;
Figur 4 einen Schnitt durch die plattenförmige Leuchte von Figur 1;
Figur 5 eine stark vergrößerte Ansicht eines Ausschnitts eines Details aus der Schnittansicht von Figur 4;
Figur 6 ein beispielhaftes Schaltbild für eine erfindungsgemäße Leuchte;
Figur 7 eine weitere Draufsicht auf die Rückseite einer erfindungsgemäßen Leuchte gemäß Figur 1 nach der Bedruckung;
Figur 8 eine schematische Draufsicht auf die Rückseite einer zweiten alternativen beispielhaften Ausführungsvariante einer erfindungsgemäßen Leuchte.
Figur 9 eine Schnittansicht durch einen vergrößerten Ausschnitt einer Lichtaustrittsplatte gemäß einer alternativen Variante der Erfindung, im Bereich einer Vertiefung, in der sich ein rundes LED-Leuchtmittel befindet;
Figur 10 eine Draufsicht auf das Detail der in Figur 9 gezeigten Schnittansicht.

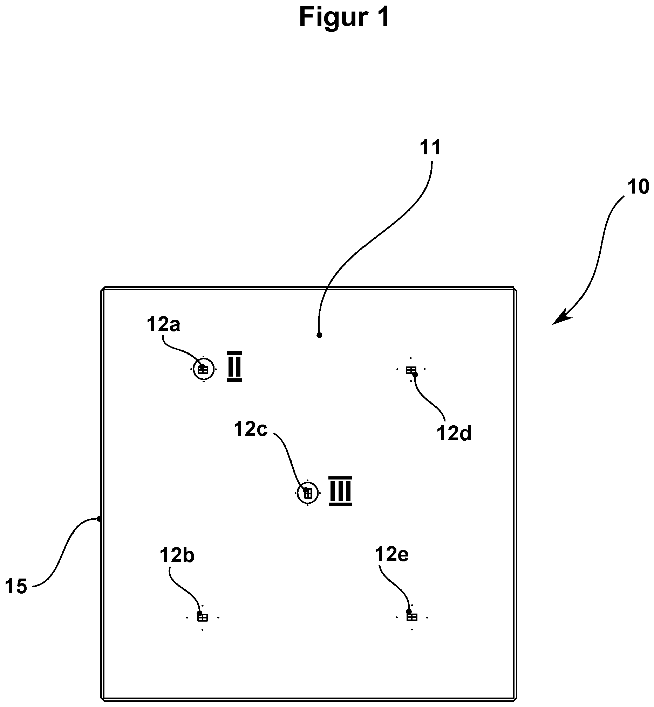

Zunächst wird auf die Figur 1 Bezug genommen und anhand dieser wird die prinzipielle Gestaltung einer beispielhaften erfindungsgemäßen Leuchte 10 mit LEDs erläutert. In diesem Ausführungsbeispiel besteht die Leuchte 10 aus einer im Umriss etwa rechteckigen flachen Lichtaustrittsplatte 11 aus einem transluzenten oder mindestens teilweise transparenten Material, welche besonders bevorzugt aus Glas besteht. Als Material kommt grundsätzlich jede Glassorte in Betracht, beispielsweise kann man gewöhnliches Floatglas verwenden. Wie man in Figur 1 erkennt, sind in das Glas der Lichtaustrittsplatte mehrere LED-Leuchtmittel 12 a, 12 b, 12 c, 12 d, 12 e eingebettet, wobei es sich um vergleichsweise kleine LEDs vom SMD-LED Typ handelt, die Abmessungen von beispielsweise im Bereich von weniger als 3 mm Länge, weniger als 2 mm Breite und einer Tiefe von zum Beispiel nur weniger als 1 mm aufweisen. Nur beispielhaft seien als im Rahmen der Erfindung geeignet LEDs mit etwa quaderförmigem Gehäuse des Herstellers Osram mit der Typenbezeichnung Duris ® S2 genannt, dies sind randlose LEDs ohne klassisches Gehäuse, die über eine hohe Lichtausbeute und einen breiten Abstrahlwinkel bei kompakten Abmessungen verfügen.

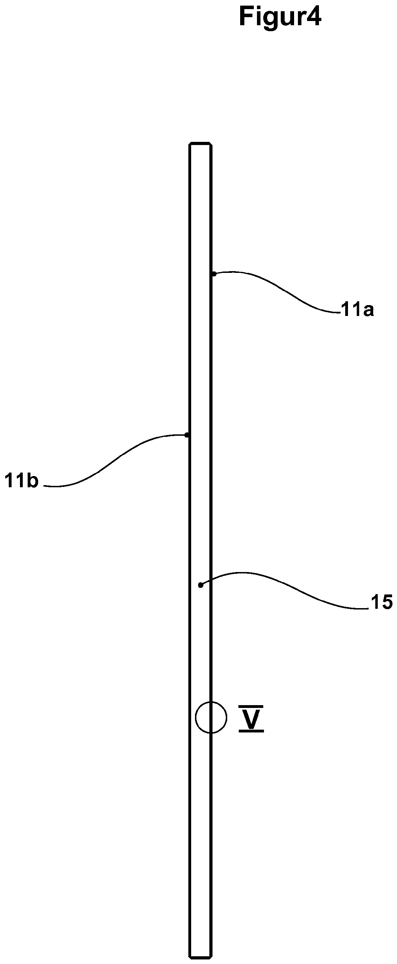

In Figur 4 erkennt man, dass die Leuchte eine geringe Aufbauhöhe hat, die im Wesentlichen nur aus der Plattenstärke der Lichtaustrittsplatte 11 resultiert, bei der es sich um eine einzige Glasplatte handeln kann, in die die LED-Leuchtmittel versenkt eingebettet sind, so dass die Leuchtmittel in der Platte völlig gegen mechanische Einflüsse geschützt sind und nicht über die Plattenoberfläche hinaus zur Rückseite 11 a der Lichtaustrittsplatte 11 hin, über die die LEDs kontaktiert werden, vorstehen. Die Vorderseite der Lichtaustrittsplatte 11, die dem Betrachter zugewandt ist und über die die Lichtabgabe überwiegend erfolgt, ist mit 11 b bezeichnet. Bei dem Grundriss der Lichtaustrittsplatte 11 gemäß dem Beispiel von Figur 1 sind Vorderseite 11 b und Rückseite 11 a jeweils rechteckige Flächen. Die Flächen, die sich an den Stirnseiten 15 der Lichtaustrittsplatte ergeben (siehe Figuren 1 und 4) können ebenso wie die Fläche an der Vorderseite 11 b beispielsweise durch Ätzen mattiert sein.

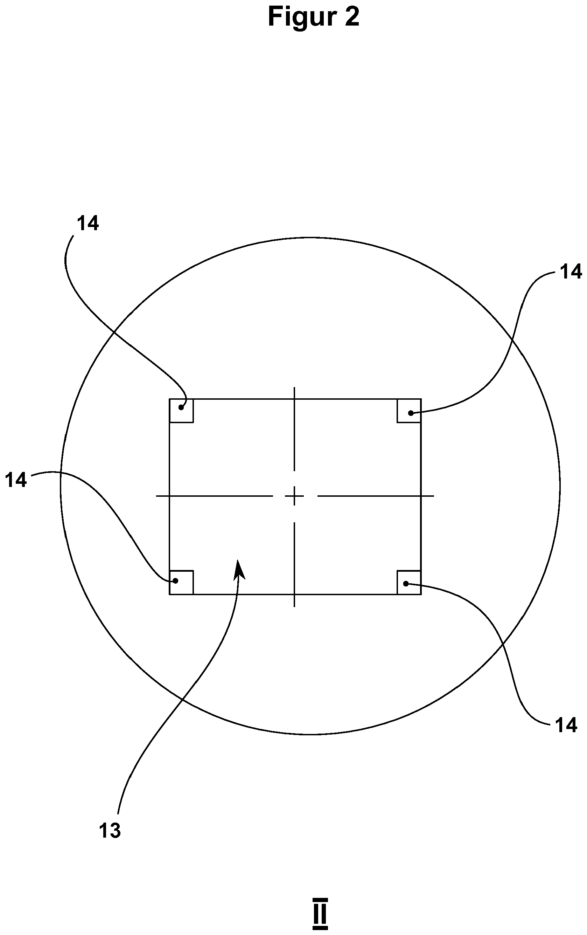

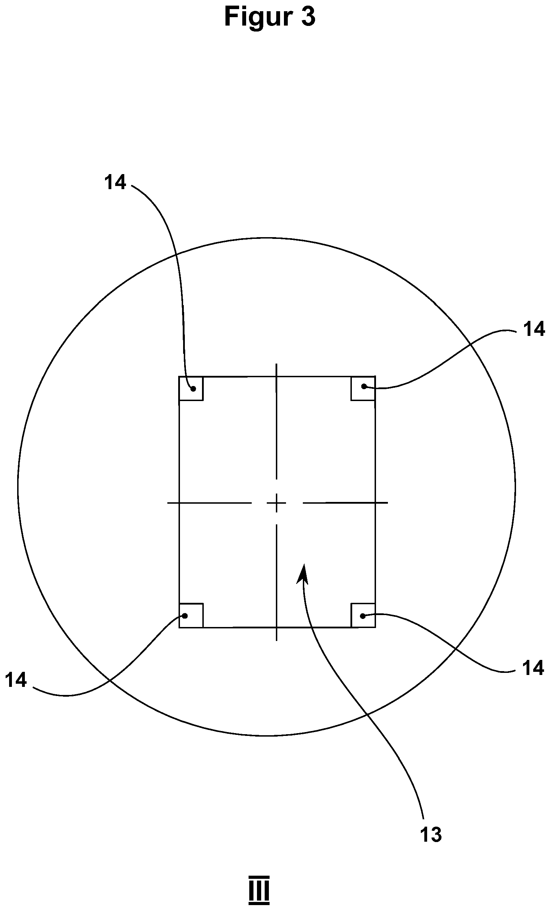

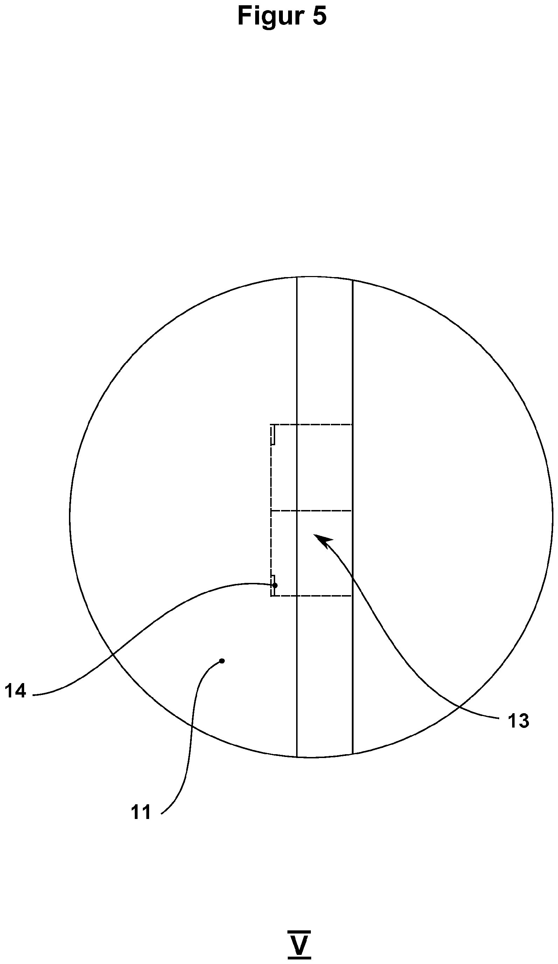

Die Figur 5 zeigt einen kleinen Detailausschnitt aus Figur 4 in vergrößertem Maßstab im Bereich einer der Vertiefungen 13, die hierin auch als Tiegel bezeichnet werden und die jeweils eines der LED-Leuchtmittel aufnehmen. Die vergrößerten Detailausschnitte aus der Draufsicht auf die Rückseite gemäß den Figuren 2 und 3 zeigen zwei dieser Vertiefungen 13 jeweils in der Draufsicht. Daraus kann man entnehmen, dass die Vertiefungen 13 jeweils einen etwa rechteckigen Umriss haben. Sie gehen nicht durch die Glasplatte 11 durch, sondern haben einen Boden ähnlich wie bei einem Sackloch. Die Einbringung der Vertiefungen 13 kann bei der Herstellung der Lichtaustrittsplatte 11 beispielsweise durch Lasern, Ätzen oder Sandstrahlen erfolgen. Diese Vertiefungen/Tiegel sind so dimensioniert, dass sie nur etwa so groß oder nur geringfügig größer sind als die LED-Leuchtmittel 12 selbst, so dass letztere quasi beim Einsetzen in die Vertiefungen passend von diesen aufgenommen werden. Die Tiefe der Vertiefungen 13, also ihre Abmessung in Richtung der Plattenstärke ist wie man aus Figur 5 sieht sehr gering und beträgt nur einen Bruchteil der Plattenstärke. Beispielsweise kann die Plattenstärke etwa 4 bis 5 mm betragen und die Tiefe einer Vertiefung jeweils nur weniger als etwa 1 mm. Die Abmessungen in Richtung der Breite und Länge der Vertiefungen (siehe Figuren 2 und 3) betragen beispielsweise etwa 2 bis 3 mm in der Länge und beispielsweise 1 bis 2 mm in der Breite. Die Abmessungen der Vertiefungen/Tiegel sind natürlich variabel abhängig von der Größe der zu verwendenden LED-Type, wobei sie wie gesagt bevorzugt so gewählt sind, dass sie an die Größe der LED angepasst sind und die Vertiefung die LED in allen drei Dimensionen nahezu passend aufnimmt. Das Ausführungsbeispiel gemäß den Figuren 1 bis 5 geht von der Verwendung von LEDs mit einem etwa quaderförmigen Gehäuse aus, wobei diese LEDs Licht zu den vier Seitenflächen und auch zur Frontfläche hin abgeben, also in Richtung der Vorderseite 11 b der Lichtaustrittsplatte 11, wo das Licht flächig austritt. Das von den Seitenflächen der LEDs zu den Seiten hin abgegebene Licht wird unmittelbar in die angrenzenden Flächen der Lichtaustrittsplatte hinein abgestrahlt, also in die Stirnseiten im Inneren der Vertiefung, so dass die Lichtaustrittsplatte dadurch als Lichtleiter fungiert und das Licht gleichmäßig in der Platte verteilt wird. Dies führt bei Verwendung von Streumitteln zu einer Lichtumlenkung und damit zu einem gleichmäßigen flächigen Austritt des Lichts über die Fläche an der Vorderseite 11 b der Lichtaustrittsplatte 11. Die Lichtumlenkung kann man zum Beispiel erreichen, indem man die Vorderseite und gegebenenfalls die stirnseitigen äußeren Flächen der Lichtaustrittsplatte 11 durch Ätzen mattiert.

Die Abmessungen der Vertiefungen 13 sind wie gesagt weitgehend passend gewählt entsprechend der mit einer quaderförmigen Blockform versehenen LED-Leuchtmittel, wobei in dem Beispiel jedoch im Bodenbereich der Vertiefung eine Ausnahme besteht, da dort jeweils minimal erhöhte Eckbereiche 14 vorhanden sind. Diese kleinen quaderförmigen Eckbereiche 14 bilden quasi kleine Podeste, auf denen die Unterseite der LED-Leuchtmittel aufliegt, d.h. an ihrer Unterseite liegt die LED nicht flächig auf, sondern nur jeweils im Eckbereich, wo sich die Podeste 14 befinden. Diese Podeste 14 in den Eckbereichen kann man auch in der Figur 5 erkennen. Wie man in dieser Zeichnung sieht, ist die Tiefe der Vertiefung 13 dort in den Eckbereichen 14 minimal verringert. Unterseitig ergibt sich daher ein schmaler Spalt zwischen der LED und dem Boden der Vertiefung. Dies kann man zum Beispiel nutzen, wenn man ein Acrylharz, einen anderen geeigneten thermoplastischen Kunststoff oder ein zähflüssiges Medium wie beispielsweise ein Silikonöl in geringer Menge in die Vertiefung gibt, wenn man die LED in diese Vertiefung einbettet. Das Acrylharz oder Silikonöl läuft dann in den schmalen Spalt zwischen der Unterseite der LED und dem Boden der Vertiefung. Mit einem solchen Kunststoff wie Acrylharz oder einem Silikonöl kann man auch die Befestigung (durch Haftverbindung) des LED-Leuchtmittels in der an dessen Form angepassten Vertiefung erreichen, wobei man nur eine kleine Menge dieses Kunststoffs oder zähflüssigen Mediums benötigt, da ja die LED weitgehend passend und mit nur wenig Spiel in der Vertiefung aufgenommen ist. Weiterhin kann diese Art des Einbettens der LED den Vorteil haben, dass ein etwaiger verbleibender Luftspalt zwischen LED und Vertiefung durch den Kunststoff oder das zähflüssige Medium überbrückt wird und damit Medien mit ähnlichen Brechungsindizes aneinander grenzen, wodurch die Lichtausbeute des LED-Leuchtmittels erhöht wird.

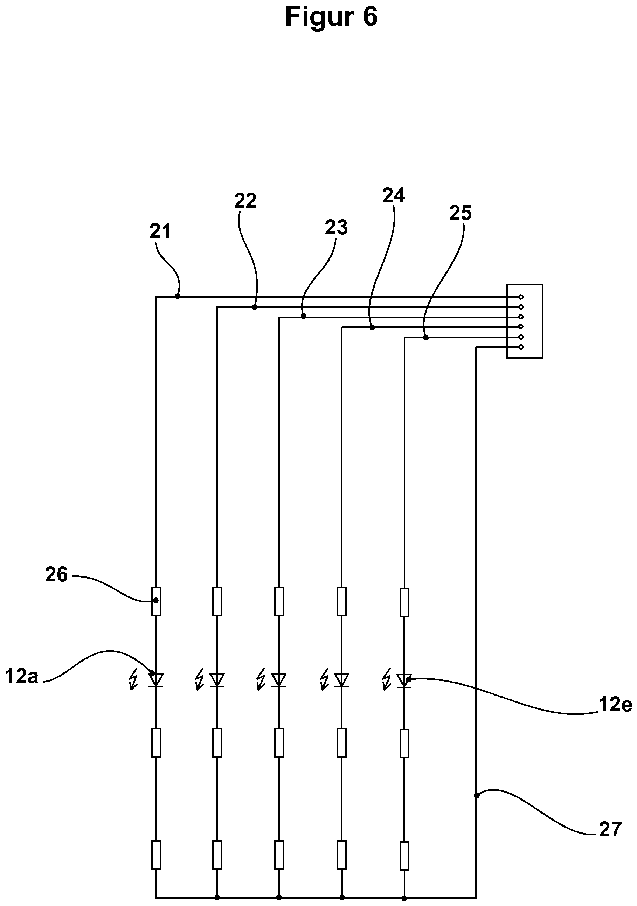

Figur 6 zeigt ein beispielhaftes Schaltbild einer erfindungsgemäßen Leuchte. Die Einspeisung des Stroms kann beispielsweise über den 6-poligen Stecker 20 mit sechs Anschlusskontakten erfolgen, von denen aus die Leitungen 21, 22, 23, 24, 25 zu den hier parallel geschalteten fünf LED-Leuchtmitteln 12 a, 12 b, 12 c, 12 d, 12 e führen, denen jeweils Vorwiderstände 26 vorgeschaltet sind, wobei es sich um 0-Ohm -Widerstände handeln kann.

Den parallel geschalteten LEDs 12a bis 12 e können jeweils weitere Widerstände nachgeschaltet sein. Die Leitungen, die die fünf LEDs versorgen münden schließlich in einer gemeinsamen Leitung 27, die zu dem Stecker 20 zurückgeführt wird, welcher der Stromeinspeisung dient und dazu beispielsweise über hier nicht eingezeichnete Kabel mit einem Netzteil verbunden werden kann.

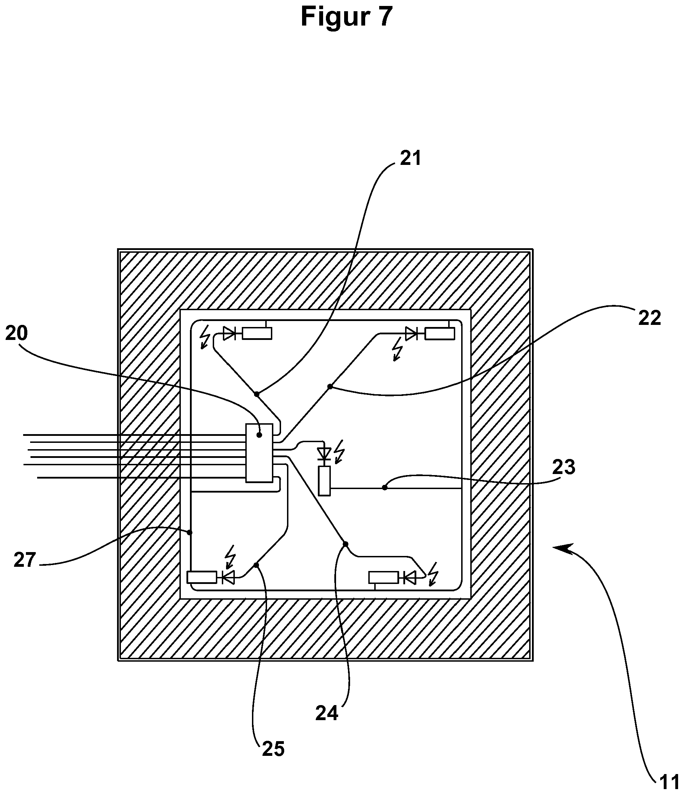

In Figur 7 ist die Draufsicht auf die Rückseite 11 a der Lichtaustrittsplatte 11 nach dem Bedruckungsvorgang dargestellt. Man erkennt hier den Stecker 20, mittels dessen die Einspeisung von Niedervoltspannung erfolgt, beispielsweise einer 5 V Gleichspannung, wie für die jeweils verwendeten LEDs benötigt, in den Hauptkontakt 15 der Lichtaustrittsplatte 11, der beispielsweise dort aufgelötet ist. Von diesem Hauptkontakt 15 aus verlaufen die Leiterbahnen 16 entsprechend den Leitungen 21 bis 25 zu den jeweiligen Kontakten 17 der LEDs (siehe dazu das Schaltbild gemäß Figur 6) sowie die Leiterbahn gemäß der Leitung 27 zu dem zweiten Pol des Hauptkontakts. Über die Leiterbahnen kann ein Lötstoplack gedruckt werden. Außerhalb des Verlaufs der Leiterbahnen kann außen rahmenförmig ein Dielektrikum 18 auf die Rückseite der Lichtaustrittsplatte 11 aufgedruckt werden.

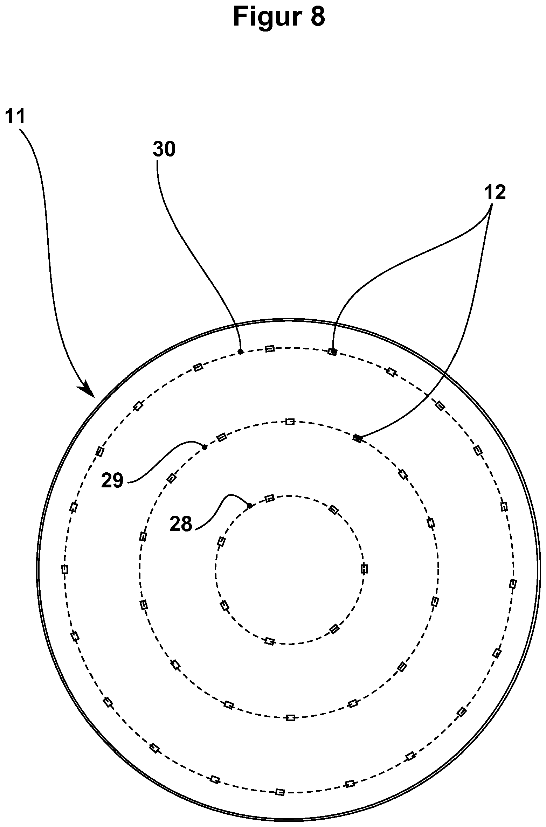

Die Figur 8 zeigt beispielhaft eine weitere alternative Ausführungsvariante, mittels derer illustriert werden soll, dass die vorliegende Erfindung quasi beliebige Grundrissformen der Lichtaustrittsplatte 11 zulässt sowie je nach gewünschten Beleuchtungseigenschaften der Leuchte eine quasi beliebig anpassbare Anzahl von LED-Leuchtmitteln 12. In diesem Beispiel hat die Lichtaustrittsplatte 11 einen runden Umriss. In diese Lichtaustrittsplatte eingelassen ist eine größere Anzahl von LED-Leuchtmitteln 12, die hier auf mehreren zueinander konzentrischen Ringen rings um den Mittelpunkt der Platte angeordnet sind. Im vorliegenden Beispiel sind es drei solcher konzentrischer Ringe von LEDs, auf dem mittigsten Ring 28 sind sieben LED-Leuchtmittel 12 angeordnet, auf dem dann nach radial außen hin folgenden Ring 29 sind es vierzehn LED-Leuchtmittel in kreisförmiger Anordnung über den Umfang verteilt in gleichmäßigen Abständen zueinander und schließlich liegen auf dem äußeren Ring 30 einundzwanzig LED-Leuchtmittel 12 in kreisförmiger Anordnung über den Umfang verteilt mit regelmäßigen Abständen untereinander. Die Vertiefungen 13 in der Lichtaustrittsplatte 11 für die Aufnahme der Leuchtmittel 12 können bei der Variante von Figur 8 ebenso wie bei der Variante von Figur 1 beispielsweise quaderförmig wie Tiegel ausgeführt sein, wenn quaderförmige LEDs des zuvor beschriebenen Typs verwendet werden sollen. Dies gilt auch für die oben beschriebenen Dimensionen und das Merkmal, dass eine Lichtleitplatte 11 bevorzugt aus Glas vorgesehen ist, in der die LED-Leuchtmittel vollständig versenkt angeordnet sind, so dass sie nach oben hin nicht über die rückseitige Oberfläche der Lichtaustrittsplatte 11 vorstehen und dort von ihrer Rückseite her kontaktiert werden können. Insoweit wird bezüglich der Variante von Figur 8 auf die obigen Ausführungen verwiesen. Diese Ausführungen von Leuchten mit in einer Glasplatte versenkten LED-Leuchtmitteln hat auch den Vorteil, dass sich die Lichtaustrittsplatte 11 mittels Automaten mit den LED-Leuchtmitteln bestücken lässt. Nach dem Einsetzen der LED-Leuchtmittel 12 kann die Kontaktierung sämtlicher LED-Leuchtmittel sowie die Aufbringung der Leiterbahnen sowie gegebenenfalls isolierender Schichten von oben her auf die Rückseite der Lichtaustrittsplatte 11 in Druckvorgängen erfolgen. Somit ist ein rationeller Fertigungsprozess in einer automatisierten Serienfertigung möglich.

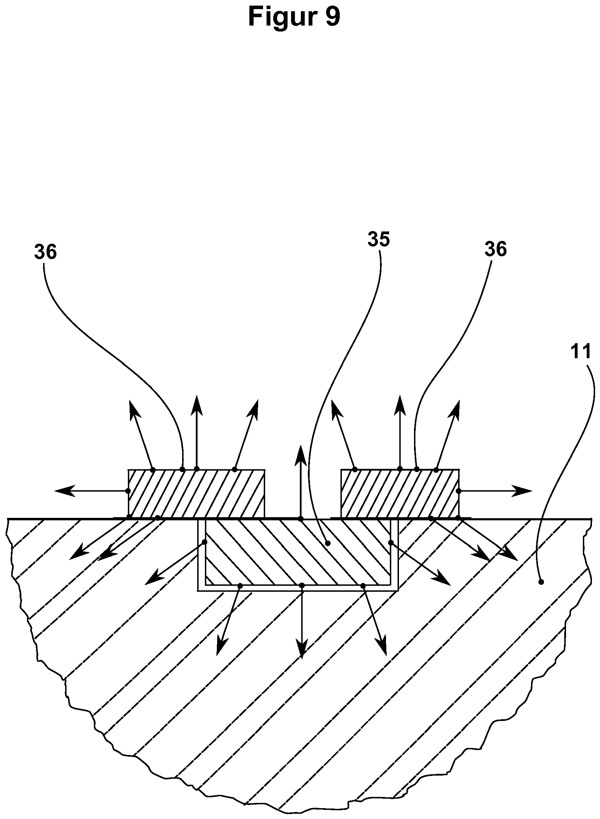

Es wird nun nachfolgend zunächst auf die Figur 9 Bezug genommen, welche eine beispielhafte alternative Variante der Erfindung zeigt. Bei dieser Variante können als Led-Leuchtmittel beispielsweise LEDs verwendet werden mit rundem vergleichsweise flachem Gehäuse, beispielsweise solche des Herstellers Osram mit der Typenbezeichnung PointLED Version 1.0 LW P4SG, die einen Durchmesser von nur etwa 2 mm aufweisen und eine Bauhöhe von weniger als 1 mm, bevorzugt von etwa 0,8 mm. Wie die Schnittansicht gemäß Figur 9 zeigt, wird auch hier die LED in einer Vertiefung der einen Lichtaustrittsplatte 11 so versenkt aufgenommen, dass die praktisch vollständig in dieser Vertiefung liegt. Die Vertiefung ist in ihrem Umriss an die Form der LED angepasst und hat entsprechend einen runden Umriss, der bevorzugt die LED nahezu passend aufnimmt, d.h. der Durchmesser der Vertiefung ist allenfalls geringfügig größer als der Durchmesser der LED. Die beiden Elektroden Anode und Kathode der LED liegen somit in einer Ebene mit der Oberfläche der Rückseite der Lichtaustrittsplatte 11 in dem Bereich, der an die Vertiefung angrenzt. Dadurch ist es möglich, zwei Kontaktblöcke 36 zu verwenden, von denen jeweils einer jeweils einerseits eine auf die Lichtaustrittsplatte aufgedruckte Leiterbahn kontaktiert und andererseits jeweils Anode bzw. Kathode der LED, so dass die elektrische Verbindung hergestellt wird zwischen jeweils einer Elektrode der LED und jeweils einer Leiterbahn. Die Kontaktblöcke 36 können aus einem gut leitenden Metall wie beispielsweise Silber oder Kupfer bestehen, so dass sie auch von den LED-Leuchtmitteln erzeugte Wärme aufnehmen und ableiten können.

Der Licht abgebende Teil 35 der LED, der das Farbmittel (dye) enthält, liegt wie Figur 9 zeigt vollständig in der Vertiefung der Lichtaustrittsplatte und kann daher sein Licht wie durch die Pfeile angedeutet zur Seite hin und nach vorn hin in die Lichtaustrittsplatte hinein abstrahlen.

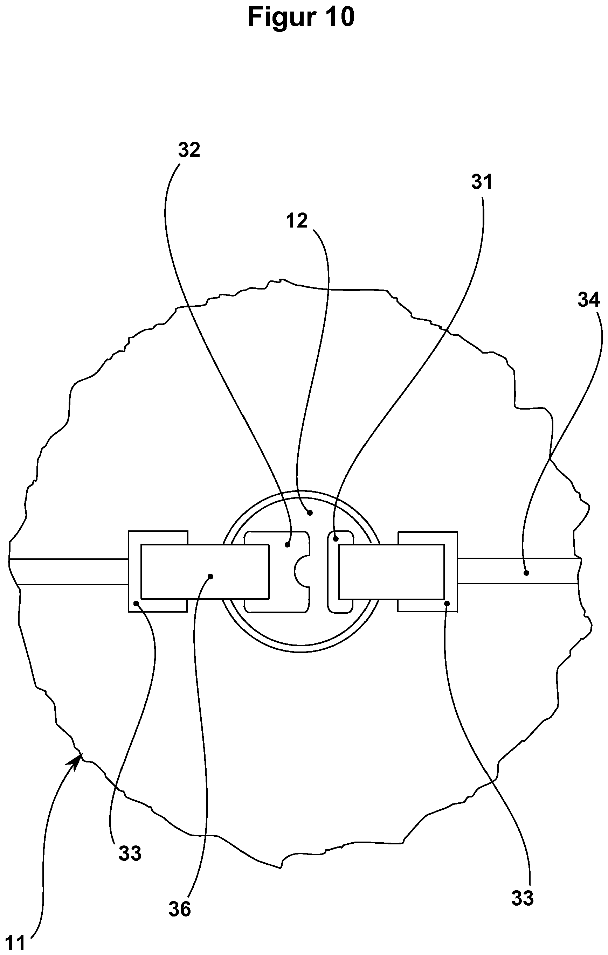

Figur 10 zeigt die Draufsicht auf den Detailausschnitt aus der Lichtaustrittsplatte, der in Figur 9 im Schnitt dargestellt ist. Hier kann man die Anode 31 und die Kathode 32 der im Umriss runden LED 12 erkennen. Die zuvor beschriebenen beiden Kontaktblöcke 36 überbrücken jeweils die Distanz von der Anode 31 bzw. der Kathode 32 zu einem auf die Lichtaustrittsplatte 11 aufgedruckten Pad 33, von dem dann jeweils eine ebenfalls auf die Lichtaustrittsplatte aufgedruckte Leiterbahn 34 ausgeht und die Kontaktblöcke 36 stellen so einen elektrischen Kontakt zwischen je einer Elektrode der LED 12 und je einer Leiterbahn 34 her.

### Bezugszeichenliste

- 10: LED-Leuchte
- 11: Lichtaustrittsplatte
- 11 a: Rückseite der Lichtaustrittsplatte
- 11 b: Vorderseite der Lichtaustrittsplatte
- 12: LED-Leuchtmittel
- 12 a bis 12 e: LED-Leuchtmittel
- 13: Vertiefungen/Tiegel
- 14: Eckbereiche/Podeste
- 15: Hauptkontakt
- 16: Leiterbahnen
- 17: Kontakte der LEDs
- 18: Dielektrikum
- 20: Stecker
- 21: Leitung
- 22: Leitung
- 23: Leitung
- 24: Leitung
- 25: Leitung
- 26: Widerstand
- 27: Leitung
- 28: mittigster Ring
- 29: folgender Ring
- 30: äußerer Ring
- 31: Anode
- 32: Kathode
- 33: aufgedrucktes Kontaktpad
- 34: Leiterbahn
- 35: Licht abgebender Teil der LED
- 36: Kontaktblöcke

## Patentansprüche

1. Leuchte (10) umfassend eine Lichtaustrittsplatte (11) aus einem mindestens teilweise lichtdurchlässigen Material, eine Anzahl LED-Leuchtmittel (12), welche ihr Licht in die Lichtaustrittsplatte (11) hinein abgeben, wobei diese LED-Leuchtmittel (12) jeweils in einer Vertiefung (13) der Lichtaustrittsplatte (11) angeordnet sind, umfassend weiter Kontaktmittel (36) zur Kontaktierung der LED-Leuchtmittel (12) sowie Mittel zur Stromversorgung der LED-Leuchtmittel, wobei die LED-Leuchtmittel (12) in nur einer Lichtaustrittsplatte (11), in den LED-Leuchtmitteln (12) zugeordneten Vertiefungen (13) dieser Lichtaustrittsplatte (11), vollständig versenkt aufgenommen sind, wobei die Höhe der LED-Leuchtmittel (12) geringer ist als die Tiefe der Vertiefungen (13) oder maximal der Tiefe der Vertiefungen entspricht, wobei die Höhe der LED-Leuchtmittel (12) weiterhin geringer ist als die Plattenstärke der Lichtaustrittsplatte (11) und die LED-Leuchtmittel (12) über auf die Rückseite (11 a) der einen Lichtaustrittsplatte (11), in der sie versenkt angeordnet sind, aufgebrachte Kontaktmittel kontaktiert werden, wobei die LED-Leuchtmittel (12) ihr Licht ausschließlich in die eine Lichtaustrittsplatte (11) hinein abstrahlen, in der sie in Vertiefungen (13) versenkt angeordnet sind und zwar sowohl seitlich zu allen Seiten hin als auch nach vorn in Plattendurchtrittsrichtung, wobei die LED-Leuchtmittel (12) in den Vertiefungen (13) der Lichtaustrittsplatte (11) so versenkt angeordnet sind, dass die an der Rückseite des LED-Leuchtmittels (12) angeordnete Anode (31) und die Kathode (32) des LED-Leuchtmittels etwa in einer Ebene mit der das LED-Leuchtmittel umgebenden Oberfläche an der Rückseite der einen Lichtaustrittsplatte (11) liegen, **dadurch gekennzeichnet, dass** die Kontaktmittel Kontaktblöcke (36) oder Kontaktplättchen aus Metall, Keramik, Glas oder Kombinationen dieser Materialien umfassen, die jeweils eine elektrische Verbindung herstellen zwischen je einer Elektrode (Anode (31) oder Kathode (32)) des LED-Leuchtmittels (12) und je einer auf die Lichtaustrittsplatte (11) aufgedruckten Leiterbahn (34), wobei über die Kontaktblöcke (36) auch eine Wärmeabfuhr erfolgt.

2. Leuchte nach Anspruch 1, **dadurch gekennzeichnet, dass** die LED-Leuchtmittel (12) auch über Kontaktmittel (33, 34, 36) der einen Lichtaustrittsplatte (11) kontaktiert werden.

3. Leuchte nach einem der Ansprüche 1 oder 2, **dadurch gekennzeichnet, dass** die Vertiefungen (13) im Umriss rechteckig ausgebildet sind und/oder die LED-Leuchtmittel (12) im Umriss rechteckig sind.

4. Leuchte nach einem der Ansprüche 1 oder 2, **dadurch gekennzeichnet, dass** die Vertiefungen (13) im Umriss rund ausgebildet sind und/oder die LED-Leuchtmittel (12) im Umriss rund sind.

5. Leuchte nach einem der Ansprüche 1 bis 4, **dadurch gekennzeichnet, dass** die Vertiefungen eine Tiefe von weniger als 1,5 mm, vorzugsweise von weniger als 1 mm aufweisen.

6. Leuchte nach einem der Ansprüche 1 bis 5, **dadurch gekennzeichnet, dass** die Materialstärke der Lichtaustrittsplatte (11) weniger als 5 mm und/oder die gesamte Aufbauhöhe der Leuchte (10) weniger als 5 mm beträgt.

7. Leuchte nach einem der Ansprüche 1 bis 6, **dadurch gekennzeichnet, dass** die Größe der Vertiefungen (13) in Richtung ihrer Länge weniger als etwa 3 mm beträgt und die Größe der Vertiefungen (13) in Richtung ihrer Breite weniger als etwa 2 mm beträgt oder dass der Durchmesser der Vertiefungen weniger als etwa 2,5 mm beträgt.

8. Leuchte nach einem der Ansprüche 1 bis 7, **dadurch gekennzeichnet, dass** in den Vertiefungen, vorzugsweise jeweils etwa in den Eckbereichen Auflagepodeste mit geringer Höhe ausgebildet sind, auf denen die LED-Leuchtmittel (12) mit ihrer Frontseite aufliegen.

9. Leuchte nach einem der Ansprüche 1 bis 8, **dadurch gekennzeichnet, dass** die LED-Leuchtmittel (12) in den Vertiefungen (13) mittels einer geringen Menge eines aushärtenden Kunststoffs oder eines dickflüssigen Mediums eingegossen oder eingebettet sind.

10. Leuchte nach einem der Ansprüche 1 bis 9, **dadurch gekennzeichnet, dass** die Rückseite der Lichtaustrittsplatte (11) mit jeweils zu den Kontakten der LED-Leuchtmittel (12) führenden Leiterbahnen bedruckt sind.

11. Leuchte nach einem der Ansprüche 1 bis 10, **dadurch gekennzeichnet, dass** die Licht abgebende Vorderseite (11 b) und/oder die Stirnseiten (15) der Lichtaustrittsplatte (11) eine vorzugsweise durch Ätzen hergestellte Mattierung aufweisen.

12. Leuchte nach einem der Ansprüche 1 bis 11, **dadurch gekennzeichnet**, das die Rückseite (11 a) der Lichtaustrittsplatte (11) gegebenenfalls in mehreren aufeinanderfolgenden Druckvorgängen mit Leiterbahnen (16) zur Versorgung der LED-Leuchtmittel (12), und/oder einem Lötstopplack und/oder einem Dielektrikum (18) bedruckt ist.

13. Leuchte nach einem der Ansprüche 1 bis 12, **dadurch gekennzeichnet, dass** eine mit Anschlussleitungen für die Stromversorgung der Leuchte verbundene Steckervorrichtung (20) unmittelbar auf die Rückseite (11 a) der Lichtaustrittsplatte (11) aufgelötet ist.

14. Leuchte nach einem der Ansprüche 1 bis 14, **dadurch gekennzeichnet, dass** wenigstens eine der Flächen der Vertiefung, insbesondere die Bodenfläche und/oder wenigstens eine der Seitenflächen der Vertiefung (13) eine wenigstens in Teilbereichen geschliffene und oder polierte Oberfläche aufweist.

## Claims

1. A lamp (10) comprising a lamp outlet plate (11) made up of an at least partially translucent material, a number of LED lighting means (12), which emit their light into the light outlet plate (11), these LED lighting means (12) in each case being arranged in a depression (13) of the light outlet plate (11), comprising further contact means (36) for contacting the LED lighting means (12) and also means for supplying power to the LED lighting means, the LED lighting means (12) being accommodated in a completely recessed manner in only one light outlet plate (11), in depressions (13) of this light outlet plate (11) assigned to the LED lighting means (12), the height of the LED lighting means (12) being smaller than the depth of the depressions (13) or at most corresponding to the depth of the depressions, the height of the LED lighting means (12) furthermore being smaller than the plate thickness of the light outlet plate (11) and the LED lighting means (12) being contacted by means of contact means applied onto the rear side (11a) of the one light outlet plate (11), in which the LED lighting means are arranged in a recessed manner, the LED lighting means (12) radiating their light exclusively into the one light outlet plate (11), in which they are arranged in a recessed manner in depressions (13), specifically both laterally towards all sides and also forwards in the plate penetration direction, the LED lighting means (12) being arranged in a recessed manner in the depressions (13) of the light outlet plate (11) in such a manner that the anode (31) arranged on the rear side of the LED lighting means (12) and the cathode (32) of the LED lighting means lie approximately in a plane with the surface surrounding the LED lighting means on the rear side of the one light outlet plate (11), **characterized in that** the contact means comprise contact blocks (36) or contact plates made from metal, ceramic, glass or combinations of these materials, which in each case produce an electrical connection between one electrode (anode (31) or cathode (32)) of the LED lighting means (12) in each case and one conductor track (34) printed onto the light outlet plate (11), wherein heat dissipation also takes place by means of the contact blocks (36).

2. The lamp according to Claim 1, **characterized in that** the LED lighting means (12) are contacted by means of contact means (33, 34, 36) of the one light outlet plate (11).

3. The lamp according to one of Claims 1 or 2, **characterized in that** the outlines of the depressions (13) are constructed in a rectangular manner and/or the outlines of the LED lighting means (12) are rectangular.

4. The lamp according to one of Claims 1 or 2, **characterized in that** the outlines of the depressions (13) are constructed in a round manner and/or the outlines of the LED lighting means (12) are round.

5. The lamp according to one of Claims 1 to 4, **characterized in that** the depressions have a depth of less than 1.5 mm, preferably of less than 1 mm.

6. The lamp according to one of Claims 1 to 5, **characterized in that** the material thickness of the light outlet plate (11) is less than 5 mm and/or the total installation height of the lamp (10) is less than 5 mm.

7. The lamp according to one of Claims 1 to 6, **characterized in that** the size of the depressions (13) in the direction of the length thereof is less than approximately 3 mm and the size of the depressions (13) in the direction of the width thereof is less than approximately 2 mm, or **in that** the diameter of the depressions is less than approximately 2.5 mm.

8. The lamp according to one of Claims 1 to 7, **characterized in that** support platforms with a low height are constructed in the depressions, preferably in the corner regions in each case, for example, against which support platforms the front side of the LED lighting means (12) bear.

9. The lamp according to one of Claims 1 to 8, **characterized in that** the LED lighting means (12) are cast or embedded in the depressions (13) by means of a small amount of a curing plastic or a viscous medium.

10. The lamp according to one of Claims 1 to 9, **characterized in that** the rear side of the light outlet plate (11) is printed with conductor tracks leading to the contacts of the LED lighting means (12) in each case.

11. The lamp according to one of Claims 1 to 10, **characterized in that** the light-emitting front side (11b) and/or the end faces (15) of the light outlet plate (11) have a matted region preferably produced by etching.

12. The lamp according to one of Claims 1 to 11, **characterized in that** the rear side (11a) of the light outlet plate (11) is printed, if appropriate in a plurality of successive printing processes, with conductor tracks (16) for supplying the LED lighting means (12), and/or a solder resist and/or a dielectric (18).

13. The lamp according to one of Claims 1 to 12, **characterized in that** a plug device (20) connected to connection strips for supplying power to the lamp is soldered directly onto the rear side (11a) of the light outlet plate (11).

14. The lamp according to one of Claims 1 to 14, **characterized in that** at least one of the surfaces of the depression, particularly the base surface and/or at least one of the side surfaces of the depression (13) has a surface which is ground and/or polished at least in part regions.

## Revendications

1. Luminaire (10) comprenant une plaque de sortie de lumière (11) composée d'un matériau laissant au moins passer partiellement la lumière, un certain nombre d'ampoules LED (12) qui diffusent leur lumière dans la plaque de sortie de lumière (11), ces ampoules LED (12) étant disposées respectivement dans un creux (13) de la plaque de sortie de lumière (11), comprenant en outre des moyens de contact (36) pour la mise en contact des ampoules LED (12) ainsi que des moyens d'alimentation électrique des ampoules LED, les ampoules LED (12) étant reçues, en étant entièrement enfoncées dans seulement une plaque de sortie de lumière (11), dans des creux (13) associés aux ampoules LED (12) de cette plaque de sortie de lumière (11), la hauteur des ampoules LED (12) étant inférieure à la profondeur des creux (13) ou équivalant au maximum à la profondeur des creux, la hauteur des ampoules LED (12) étant en outre inférieure à l'épaisseur de plaque de la plaque de sortie de lumière (11) et les ampoules LED (12) étant en contact par des moyens de contact installés sur la face arrière (11a) de la plaque de la plaque de sortie de lumière (11) dans laquelle elles sont disposées en étant enfoncées, les ampoules LED (12) diffusant leur lumière exclusivement dans la plaque de la plaque de sortie de lumière (11) dans laquelle elles sont disposées en étant enfoncées, c'est-à-dire qu'elles sont disposées en étant enfoncées aussi bien latéralement en direction de tous les côtés que vers l'avant dans le sens de traversée de la plaque, les ampoules LED (12) étant disposées en étant enfoncées dans les creux (13) de la plaque de la plaque de sortie de lumière (11) de manière à ce que l'anode (31) disposée sur la face arrière de l'ampoule LED (11) et que la cathode (32) de l'ampoule LED se trouvent approximativement dans un plan avec la surface entourant l'ampoule LED à la face arrière de la plaque de la plaque de sortie de lumière (11), **caractérisé en ce que** les moyens de contact comprennent des blocs de contact (36) ou des plaquettes de contact en métal, céramique, verre ou combinaison de ces matériaux qui établissent respectivement une liaison électrique entre chaque fois une électrode (anode (31) ou cathode (32)) de l'ampoule LED (12) et chaque fois une piste conductrice imprimée sur la plaque de sortie de lumière (11), une évacuation thermique ayant également lieu par l'intermédiaire des blocs de contact (36).

2. Luminaire selon la revendication 1, **caractérisé en ce que** les ampoules LED (12) sont aussi mises en contact par des moyens de contact (33,34,36) de la plaque de sortie de lumière (11).

3. Luminaire selon une des revendications 1 ou 2, **caractérisé en ce que** les creux (13) ont un contour à conformation rectangulaire et/ou que les ampoules LED (12) ont un contour à conformation rectangulaire.

4. Luminaire selon une des revendications 1 ou 2, **caractérisé en ce que** les creux (13) ont un contour de conformation ronde et/ou les ampoules LED (12) ont un contour de conformation ronde.

5. Luminaire selon une des revendications 1 à 4, **caractérisé en ce que** les creux présentent une profondeur de moins de 1,5 mm, de préférence de moins de 1 mm.

6. Luminaire selon une des revendications 1 à 5, **caractérisé en ce que** l'épaisseur de matériau de la plaque de sortie de lumière (11) est de moins de 5 mm et/ou la hauteur structurelle totale du luminaire (10) est de moins de 5 mm.

7. Luminaire selon une des revendications 1 à 6, **caractérisé en ce que** la taille des creux (13) dans le sens de leur longueur est de moins d'environ 3 mm et que la taille des creux (13) dans le sens de la largeur et de moins d'environ 2 mm ou que le diamètre des creux est de moins d'environ 2,5 mm.

8. Luminaire selon une des revendications 1 à 7, **caractérisé en ce que**, dans les creux, de préférence respectivement approximativement au niveau des angles, sont réalisées des plates-formes d'appui de faible hauteur sur lesquelles les ampoules LED (12) reposent par leur face frontale.

9. Luminaire selon une des revendications 1 à 8, **caractérisé en ce que** les ampoules LED (12) sont coulées ou encastrées dans les creux (13) au moyen d'une faible quantité d'un plastique durci ou d'un fluide épais.

10. Luminaire selon une des revendications 1 à 9, **caractérisé en ce que** la face arrière de la plaque de sortie de lumière (11) est imprimée respectivement avec des pistes conductrices menant respectivement vers les contacts des ampoules LED (12).

11. Luminaire selon une des revendications 1 à 10, **caractérisé en ce que** la face avant diffusant la lumière (11b) et/ou les faces frontales (15) de la plaque de sortie de lumière (11) présentent un aspect mat obtenu de préférence par gravure.

12. Luminaire selon une des revendications 1 à 11, **caractérisé en ce que** la face arrière (11a) de la plaque de sortie de lumière (11) est imprimée le cas échéant en plusieurs opérations d'impression successives avec des pistes conductrices (16) pour alimenter les ampoules LED (12) et/ou avec un vernis d'arrêt de soudure et/ou un diélectrique (18).

13. Luminaire selon une des revendications 1 à 12, **caractérisé en ce qu'**un dispositif de prise (20) raccordé à des câbles de raccordement pour l'alimentation électrique du luminaire est brasé directement sur la face arrière (11a) de la plaque de sortie de lumière (11).

14. Luminaire selon une des revendications 1 à 14, **caractérisé en ce qu'**au moins une des surfaces du creux, en particulier la surface de fond et/ou une des surfaces latérales du creux (13), est une surface meulée et/ou polie au moins dans des zones partielles.
